# EUROPEAN PATENT APPLICATION

(11) **EP 4 769 044 A1**
(43) Date of publication of application: **01.07.2026**
(21) Application number: 24902513.1
(22) Date of filing: 20.11.2024
(51) Int. Cl.: G05B 23/02

(54) **TEST METHOD, SYSTEM, APPARATUS AND DEVICE FOR ENERGY STORAGE CONTROL SYSTEM, AND STORAGE MEDIUM**

(30) Priority: 15.12.2023 CN 202311736915
(71) Applicant: Contemporary Amperex Future Energy Research Institute (Shanghai) Limited, Shanghai 200241 (CN); Contemporary Amperex Technology Co., Limited, Ningde, Fujian 352100 (CN)
(72) Inventor: XU, Liumao, Shanghai 200241 (CN)
(74) Representative: Gong, Jinping
(86) International application number: PCT/CN2024/133332
(87) International publication number: WO 2025/124091

(57) **Abstract**

Disclosed are a testing method, testing system, and apparatus for an energy storage control system, a device, and a storage medium. Test indication information is received (S201); an associated device connected to a device under test in an energy storage control system is simulated based on the test indication information, and a simulation associated parameter is determined (S202); and the device under test is tested based on the simulation associated parameter and the test indication information, and a test result of the device under test is received (S203). A testing device (104) can simulate any device associated with the device under test in the energy storage control system, specifically by simulating the interface implementation and functional execution logic implementation of any device. Through the simulation associated parameter, the above simulated interface implementation or functional implementation is achieved. Therefore, the testing process is not limited to testing a specific type of device under test and can achieve various types of testing, thereby improving the applicability of the testing method to some extent.

## Description

### CROSS REFERENCE

The present application claims priority to Chinese Patent Application No. 2023117369154, filed on December 15, 2023, entitled "TESTING METHOD, TESTING SYSTEM, AND APPARATUS FOR ENERGY STORAGE CONTROL SYSTEM, DEVICE, AND STORAGE MEDIUM," which is incorporated herein by reference in its entirety.

### TECHNICAL FIELD

The present application relates to the field of flexible DC energy storage valve testing technologies, and in particular to a testing method, testing system, and apparatus for an energy storage control system, a device, and a storage medium.

### BACKGROUND

A control and protection system of a flexible direct current energy storage valve serves as the "brain" of energy storage valve products, playing a critical role in energy conversion between a flexible direct current system and a battery control system. This control and protection system collaborates with multiple systems, including a flexible direct current control system, valve cooling system, fire protection system, battery control system, and submodule control system, to achieve functions such as startup, charge-discharge control, and protection of the energy storage valve.

In related technologies, a testing system for an energy storage valve control system typically relies on a relay protection tester to verify some interface functions. Most of these tests are conducted under conditions where the system is shut down, or where certain control and protection functions are disabled. However, it is difficulty for the aforementioned relay protection tester to meet the testing requirements for control and protection systems of energy storage valve control.

### SUMMARY OF THE INVENTION

In view of this, it is necessary to address the above technical problems by providing a testing method, testing system, and apparatus for an energy storage control system, a device, and a storage medium, which can efficiently test a control and protection system of energy storage valve control according to testing requirements.

According to a first aspect, the present application provides a testing method for an energy storage control system, the testing method is applied to a testing device, and the testing method includes:
receiving test indication information;
simulating, based on the test indication information, an associated device connected to a device under test in the energy storage control system, and determining a simulation associated parameter; where the simulation associated parameter includes a simulation interface parameter or a simulation functional parameter; and
testing the device under test based on the simulation associated parameter and the test indication information, and receiving a test result of the device under test.

The testing method for the energy storage control system described in the embodiments of the present application involves receiving the test indication information, based on the test indication information, simulating the associated device connected to the device under test in the energy storage control system, determining the simulation associated parameter, testing the device under test based on the simulation associated parameter and the test indication information, and receiving the test result of the device under test. In the above testing method, the testing device may simulate any device associated with the device under test in the energy storage control system, specifically by simulating the interface implementation and functional execution logic implementation of any device. Through the simulation associated parameter, the above simulated interface implementation or functional implementation is achieved, enabling the testing method to perform data interaction with the device under test via the simulated interface implementation or functional logic implementation to complete the testing. Therefore, the testing process is not limited to testing a specific type of device under test and can achieve various types of testing, such as interface testing of the device under test or functional testing of the device under test, thereby improving the applicability of the testing method to some extent.

In one embodiment, the simulating, based on the test indication information, an associated device connected to a device under test in the energy storage control system, and determining a simulation associated parameter includes:
obtaining a preset point configuration table; and
simulating the associated device based on the preset point configuration table and a test type indicated by the test indication information, and determining the simulation associated parameter.

The method described in the embodiments of the present application configures the associated device using the preset point configuration table, enabling the simulation of any type of associated device connected to the device under test on the local device. Information exchange between the testing module and the device under test is implemented by switching any type of simulation associated parameter, to achieve various types of testing. This testing process does not require testing based on the device under test and the actual associated device connected, simplifying the physical machines required for testing to some extent, especially for multiple types of testing. Additionally, the testing device itself occupies less space, eliminating the need for a large layout of physical machines and being unrestricted by environmental constraints, thereby enhancing the applicability of the method to some extent.

In one embodiment, the simulation associated parameter includes a simulation interface parameter, and the simulating the associated device based on the preset point configuration table and a test type indicated by the test indication information, and determining the simulation associated parameter includes:
if the test type indicated by the test indication information is interface testing, extracting interface configuration information from the preset point configuration table; and
configuring relevant interfaces of various types in the associated device based on the interface configuration information, and determining the simulation interface parameter.

The method described in the embodiments of the present application configures the relevant interfaces of various types in the associated device using the preset point configuration table, enabling the simulation of any type of interface on the local device. Information exchange between the testing interface and the corresponding interface of the device under test is implemented by switching any type of simulation interface parameter, to achieve various types of interface testing. This testing process does not require testing based on the actual interface of the device under test and the actual interface of the associated device, thereby improving the applicability of the method to some extent.

In one embodiment, the simulation associated parameter includes a simulation functional parameter, and the simulating, based on a preset point configuration table and a test type indicated by the test indication information, the associated device connected to the device under test in the energy storage control system, and determining the simulation associated parameter includes:
if the test type indicated by the test indication information is functional testing, extracting test logic of each functional module in the associated device from the preset point configuration table; and
performing logic circuit configuration based on the test logic of each functional module in the associated device to generate the simulation functional parameter.

The method described in the embodiments of the present application configures each functional module in the associated device using the preset point configuration table, enabling the simulation of test logic for each function on the local device. That is, a testing module is configured on the local device to simulate the corresponding functional implementation of the associated device. Through the functional module implemented by the simulation functional parameter, information interaction with the device under test is performed to achieve corresponding functional testing. This testing method can test the correctness of the execution logic of each function implemented on the device under test, thereby enabling testing of software processes.

In one embodiment, the obtaining a preset point configuration table includes:
receiving the preset point configuration table; where the preset point configuration table includes interface configuration information for at least one type of relevant interface and functional configuration information for at least one type of functional module, each piece of the interface configuration information includes an operating parameter of a corresponding interface, and each piece of the functional configuration information includes test logic of a corresponding functional module.

The method described in the embodiments of the present application can receive the preset point configuration table to configure the testing module on the local device, enabling rapid configuration and thereby improving testing efficiency.

In one embodiment, the testing the device under test based on the simulation associated parameter and the test indication information, and receiving a test result of the device under test includes:
parsing the test indication information to obtain a first test task; and
configuring a testing module of a local device based on the simulation associated parameter, driving the configured testing module to execute the first test task to test the device under test, and receiving a test result that is obtained by testing the device under test based on the first test task.

The testing method provided in the embodiments of the present application only requires issuing the test indication information to the testing device. The testing device may automatically parse the test indication information to obtain the test task and automatically simulate any associated device to complete the testing, thereby achieving a fully automated testing method for the energy storage control system.

In one embodiment, the simulation associated parameter includes a simulation functional parameter, the testing module includes a functional module, and the driving the configured testing module to execute the first test task to test the device under test, and receiving a test result that is obtained by testing the device under test based on the first test task includes:
driving the configured functional module to generate abnormality information based on a test parameter in the first test task; where the simulation functional parameter includes any one of input functional parameter, network communication functional parameter, optical fiber communication functional parameter, and output functional parameter; and
sending the abnormality information to the device under test for testing, and receiving the test result that is obtained by testing the device under test based on the first test task.

The method described in the embodiments of the present application implements a short-term fault insertion testing function. Through simulation to generate the abnormality information for testing, the testing can be refined to simulate abnormalities such as cyclic redundancy check and frame loss at high-speed communication interfaces, as well as simulate faults with durations at the microsecond level.

In one embodiment, the abnormality information includes an abnormal message, and the sending the abnormality information to the device under test for testing, and receiving the test result that is obtained by testing the device under test based on the first test task includes:
sending the abnormal message to the device under test for testing according to a preset sending cycle, and receiving the test result that is obtained by testing the device under test based on the first test task.

The method described in the embodiments of the present application implements a short-term fault insertion testing function. Through simulation to generate the abnormal message for testing, the testing can be refined to simulate abnormalities such as cyclic redundancy check and frame loss at high-speed communication interfaces, as well as simulate faults with durations at the microsecond level.

In one embodiment, the simulation associated parameter includes a simulation interface parameter, and the driving the configured testing module to execute the first test task to test the device under test, and receiving a test result that is obtained by testing the device under test based on the first test task includes:
generating an abnormal signal based on a test parameter in the first test task and a type of the simulation interface parameter; and
driving the configured testing module to send the abnormal signal to the device under test for testing, and receiving the test result that is obtained by testing the device under test based on the first test task.

The method described in the embodiments of the present application implements another fault insertion testing function. Through simulation to generate the abnormal signal for testing, the testing can be refined to simulate abnormalities such as cyclic redundancy check and frame loss at high-speed communication interfaces.

In one embodiment, the first test task includes multiple test subtasks, and the driving the configured testing module to execute the first test task to test the device under test, and receiving a test result that is obtained by testing the device under test based on the first test task includes:
determining a first test parameter based on a first test subtask in the first test task;
driving the configured testing module to generate a first operating parameter based on the first test parameter;
sending the first operating parameter to the device under test for testing, and receiving a first test result that is obtained by testing the device under test based on the first operating parameter; and
if the first test result indicates that the device under test is in a normal operating state, determining a new first test parameter and a new first operating parameter based on a next test subtask, and returning to the step of driving the configured testing module to generate the first operating parameter based on the first test parameter until all test subtasks are completed.

The method described in the embodiments of the present application implements a continuous state testing method or a continuous logic testing method. The testing is completed by simulating the interaction between a battery controller, a submodule controller, and a valve control protection system, thereby improving testing efficiency. In some embodiments, the testing method provided in the embodiments of the present application achieves a fully automated testing method by parsing multiple test subtasks for testing, or test complex logical relationships by editing the logical relationships between multiple test subtasks.

In one embodiment, the method further includes:
establishing a communication connection between the configured testing module and the device under test;
sending a second operating parameter to the device under test, and receiving a second test result that is obtained by testing the device under test based on the second operating parameter; and
if the second test result indicates that the device under test is in a fault-cleared state, executing the step of parsing the test indication information to obtain a first test task.

The embodiments of the present application implement a fault detection method, where fault detection can be completed based on multiple interaction steps, thereby achieving an automated fault detection method.

In one embodiment, the establishing a communication connection between the configured testing module and the device under test includes:
extracting communication protocol information from a preset point configuration table; and
establishing the communication connection between the configured testing module and the device under test based on the communication protocol information.

In the embodiments of the present application, the communication connection between the configured testing module and the device under test is established using the preset point configuration table. Since the preset point configuration table has a tree structure, the communication connection can be quickly established based on the preset point configuration table, thereby improving testing efficiency.

In one embodiment, the method further includes:
reporting the test result to a host computer.

In the method described in the embodiments of the present application, the testing device may report the test result of each test subtask or test task to the host computer, so that a user of the host computer can view the test result in a timely manner, or update or modify the test parameter based on the test result, and then issue new test indication information for testing.

According to a second aspect, the present application provides a testing system for energy storage valve control, where the testing system includes a host computer, a testing device, and an energy storage control system, and the energy storage control system includes at least a submodule controller, a main control chassis, and an expansion device; where
the testing device is configured to receive test indication information sent by the host computer, simulate, based on the test indication information, an associated device connected to a device under test in the energy storage control system, determine a simulation associated parameter, test the device under test based on the simulation associated parameter and the test indication information, and receive a test result of the device under test; where the simulation associated parameter includes a simulation interface parameter or a simulation functional parameter.

According to a third aspect, the present application provides a testing apparatus for an energy storage control system, where the testing apparatus includes:
a receiving module configured to receive test indication information;
a simulation module configured to: simulate, based on the test indication information, an associated device connected to a device under test in the energy storage control system, and determine a simulation associated parameter; where the simulation associated parameter includes a simulation interface parameter or a simulation functional parameter; and
a testing module configured to test the device under test based on the simulation associated parameter and the test indication information, and receive a test result of the device under test.

According to a fourth aspect, the present application provides a testing apparatus for an energy storage control system, and the testing apparatus includes:
a sending module configured to send test indication information to a testing device;
a receiving module configured to receive a test result returned by the testing device after simulating, based on the test indication information, an associated device connected to a device under test in the energy storage control system to obtain a simulation associated parameter, and testing the device under test based on the simulation associated parameter and the test indication information; the simulation associated parameter includes a simulation interface parameter or a simulation functional parameter.

According to a fifth aspect, the present application further provides a computer device. The computer device includes a memory and a processor, the memory stores a computer program, and when the processor executes the computer program, the method described in the first aspect or the second aspect is implemented.

According to a sixth aspect, the present application further provides a computer-readable storage medium. The computer-readable storage medium stores a computer program, and when the computer program is executed by a processor, the method described in the first aspect or the second aspect is implemented.

The above description is merely an overview of the technical solutions of the present application. To provide a clearer understanding of the technical means of the present application, the content of the specification can be implemented, and to make the above and other objectives, features, and advantages of the present application more apparent and understandable, specific embodiments of the present application are exemplified below.

### DESCRIPTION OF THE DRAWINGS

To more clearly illustrate the technical solutions of the embodiments of the present application, the drawings required for use in the embodiments of the present application are briefly introduced below. Obviously, the drawings described below are only some embodiments of the present application. For those of ordinary skill in the art, other drawings can be obtained based on these drawings without creative effort. In the drawings:
FIG. 1 is a schematic structural diagram of a testing system in one embodiment;
FIG. 2 is a schematic flowchart of a testing method for an energy storage control system in one embodiment;
FIG. 3 is a schematic flowchart of a testing method for an energy storage control system in another embodiment;
FIG. 4 is a schematic diagram of a preset point configuration table in one embodiment;
FIG. 5 is a schematic flowchart of a testing method for an energy storage control system in another embodiment;
FIG. 6 is a schematic flowchart of a testing method for an energy storage control system in another embodiment;
FIG. 7 is a schematic flowchart of a testing method for an energy storage control system in another embodiment;
FIG. 8 is a schematic flowchart of a testing method for an energy storage control system in another embodiment;
FIG. 9 is a schematic flowchart of a testing method for an energy storage control system in another embodiment;
FIG. 10 is a schematic flowchart of a testing method for an energy storage control system in another embodiment;
FIG. 11 is a schematic flowchart of a testing method for an energy storage control system in another embodiment;
FIG. 12 is a schematic flowchart of a testing method for an energy storage control system in another embodiment;
FIG. 13 is a schematic flowchart of a testing method for an energy storage control system in another embodiment;
FIG. 14 is a schematic flowchart of a testing method for an energy storage control system in another embodiment;
FIG. 15 is a schematic flowchart of a testing method for an energy storage control system in another embodiment;
FIG. 16 is a schematic flowchart of a testing method for an energy storage control system in another embodiment;
FIG. 17 is a schematic structural diagram of a testing apparatus for an energy storage control system in one embodiment; and
FIG. 18 is an internal structural diagram of a computer device in one embodiment.

### DETAILED DESCRIPTION

To make the objectives, technical solutions, and advantages of the present application clearer, the present application is further described in detail below with reference to the drawings and embodiments. It should be understood that the specific embodiments described here are only used to explain the present application and are not intended to limit the present application.

Unless otherwise defined, all technical and scientific terms used herein have the same meaning as commonly understood by those skilled in the technical field of the present application. The terms used herein are only for the purpose of describing specific embodiments and are not intended to limit the present application. The terms "include" and "have" and any variations thereof in the specification, claims, and the above description of the drawings of the present application are intended to cover non-exclusive inclusion.

In the description of the embodiments of the present application, technical terms such as "first" and "second" are only used to distinguish different objects and should not be understood as indicating or implying relative importance or implicitly indicating the number, specific order, or priority relationship of the indicated technical features. In the description of the embodiments of the present application, "multiple" means two or more unless explicitly and specifically defined otherwise.

Reference to "embodiment" herein means that a specific feature, structure, or characteristic described in connection with the embodiment may be included in at least one embodiment of the present application. The appearance of this phrase in various places in the specification does not necessarily refer to the same embodiment, nor is it an independent or alternative embodiment mutually exclusive with other embodiments. Those skilled in the art explicitly and implicitly understand that the embodiments described herein can be combined with other embodiments.

A control and protection system of flexible direct current energy storage valve control serves as the "brain" of energy storage valve products, playing a critical role in energy conversion between a flexible direct current system and a battery control system. This control and protection system collaborates with multiple systems, including a flexible direct current control system, valve cooling system, fire protection system, battery control system, and submodule control system, to achieve functions such as startup, charge-discharge control, and protection of the energy storage valve.

However, currently, control and protection systems of energy storage valve control lack a static testing system and method similar to those for relay protection products. Static testing of control and protection systems often relies on relay protection testers to verify certain interface functions, and barely covers, for instance, different forms of optical fiber communication such as gigabit networks, FT3, and Aurora. Additionally, the lack of effective testing systems for control and protection systems of energy storage valve control results in that in scenarios of shut down, partial control, and protection functions being disabled, relay protection testers barely complete the testing or verification purpose when there are testing requirements for projects such as electromagnetic compatibility (Electromagnetic Compatibility, EMC) testing, climatic environment testing, and mechanical performance testing. In some embodiments, systems using relay protection testers for testing or verification require a large number of physical objects, resulting in a testing platform that is heavy and occupies a large area, making transportation and setup difficult. Such testers are not suitable for EMC, climatic environment, or mechanical performance testing. In addition, the testing systems cannot achieve automated testing. To address these issues, the embodiments of the present application provide a testing method and testing system for energy storage valve control. The testing method and testing system provided in the embodiments of the present application are specifically described in the following embodiments.

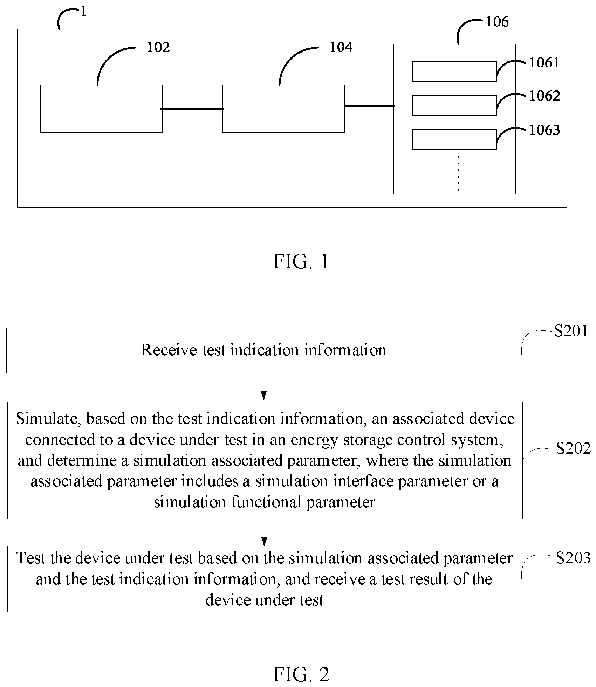

The testing method for energy storage control and protection provided in the embodiments of the present application can be applied to a testing system 1 as shown in FIG. 1. The testing system includes a host computer 102, a testing device 104, and an energy storage valve control and protection system 106. The testing device 104 is connected to the host computer 102 and the energy storage valve control and protection system 106, respectively. The host computer 102 can communicate with the testing device 104 via wired or wireless means. The testing device 104 can communicate with the energy storage valve control and protection system 106 via wired or wireless means. The host computer 102 can be, but is not limited to, various personal computers, laptops, smartphones, tablets, IoT devices, and portable wearable devices. IoT devices may include smart speakers, smart TVs, smart air conditioners, and smart in-vehicle devices. Portable wearable devices may include smart watches, smart bracelets, and head-mounted devices. In some embodiments, the host computer 102 can also be implemented as an independent server or a server cluster composed of multiple servers. The testing device 104 can be used to simulate any device or apparatus in the energy storage valve control and protection system 106 and can be, but is not limited to, various personal computers, laptops, smartphones, tablets, and servers. The energy storage valve control and protection system 106 includes at least a submodule controller 1061, a main control chassis 1062, and an expansion device 1063.

Those skilled in the art can understand that the testing system shown in FIG. 1 is only a block diagram of a partial structure related to the solution of the present application and does not constitute a limitation on the testing system to which the solution of the present application is applied. A specific testing system may include more or fewer components than shown in the figure, or combine certain components, or have a different arrangement of components.

In one embodiment, as shown in FIG. 2, a testing method for energy storage control and protection is provided, which is described by taking the method applied to the testing device in FIG. 1 as an example, including the following steps.

S201. Receive test indication information.

The test indication information may include a test case, a test script, a state sequence, a test parameter, an operating parameter, indication information, or the like. The indication information is used to indicate the test type. For example, the indication information can be used to indicate that the test type is interface testing, meaning it is used to indicate testing the communication or interaction function of an interface in an energy storage control system. The indication information can also be used to indicate that the test type is functional testing, meaning it is used to indicate testing the functional logic in the energy storage control system, such as judging and testing the logic for implementing each function.

In some embodiments, the testing device may receive test indication information sent by the host computer. The host computer is installed with host computer testing software and can interact with the testing device via the TCP/IP protocol. The host computer is used for tasks such as monitoring the testing device, developing and executing test scripts, and generating test reports. The host computer can be equipped with a human-machine interaction interface, an automated testing and debugging interface, and a point configuration table setup interface. Users can select test objects, edit test tasks, or modify test parameter based on the human-machine interaction interface. Users can also issue test indication information for testing based on the automated testing and debugging interface. Users can also build a preset point configuration table based on the point configuration table setup interface. Testing instruction

The testing device is used to simulate various external devices or systems (that is, associated devices) that communicate with any device in the energy storage control system. For example, the testing device may simulate various external systems or devices that communicate with a main control apparatus, including merging units, vehicle stability control (Vehicle Stability Control, VSC) systems for energy storage valve control, fire protection systems, and valve cooling systems. Alternatively, the testing device may simulate various external systems or devices that communicate with an expansion chassis, including submodule systems. Furthermore, the testing device may simulate various external systems or devices that communicate with a submodule controller, including energy storage valve control systems, battery control systems, isolation switches, bypass switches, and insulated-gate bipolar transistors (Insulate-Gate Bipolar Transistor, IGBT). The testing device is installed with testing software, and the testing software has configuration processing functions, including configuration file parsing and distribution functions, such as a point configuration table for communication between the testing device and the host computer, as well as configuration information for various hardware boards and interfaces at the bottom layer of the testing device. In some embodiments, the testing device includes a test task execution engine for parsing state sequences included in test instructions issued by the host computer and executing the parsed test tasks, with transition conditions between the test tasks determined by the testing device. In some embodiments, the testing device is equipped with a program for communicating with the testing software of the host computer, including one or more programs for data read/write, test task issuance, file transfer, abnormal message generation, abnormal signal generation, and the like. In some embodiments, the testing software on the testing device also has an event recording function, which performs real-time detection of signals marked as events in the point configuration table and records signals that change state.

In the embodiments of the present application, when it is necessary to test any device in the energy storage control system, the host computer or other devices can issue the test indication information to the testing device by sending test scripts, a test case, a state sequence, or indication information. The testing device may then receive the test indication information. In some embodiments, the above test scripts, test case, state sequence, or indication information can be pre-stored in the host computer or other devices. When the host computer or other devices trigger testing, the host computer or other devices directly retrieve the above test scripts, test case, state sequence, or indication information to generate test instructions for issuance. In some embodiments, users can edit the above test scripts, test case, state sequence, or indication information online to generate the test indication information for issuance.

S202. Simulate, based on the test indication information, an associated device connected to a device under test in the energy storage control system, and determine a simulation associated parameter, where the simulation associated parameter includes a simulation interface parameter or a simulation functional parameter.

The energy storage control system includes a submodule controller, a main control chassis, an expansion device, a battery controller, an isolation switch circuit, a bypass switch circuit, and an energy storage valve control and protection system. The test result includes a test result for testing any device in the energy storage control system. Testing of the energy storage control system includes fault testing of components or interfaces, state testing, or logic function testing of hardware (or software). The simulation interface parameter is an implementation parameter that is for a hardware or software interface corresponding to each interface in the energy storage control system and that is implemented through software or hardware on the testing device. The simulation functional parameter is an implementation parameter that is for a logic circuit module, software module, or program module corresponding to each functional module or functional item in the energy storage control system and that is implemented through software or hardware on the testing device. Specifically, a corresponding testing module on the local device may be configured through the simulation interface parameter to obtain a simulated interface similar to the interface implementation, and a corresponding testing module on the local device may be configured through the simulation functional parameter to obtain a simulated functional module similar to the interface implementation.

The device under test can be any one or more devices in the energy storage control system. Correspondingly, the associated device of the device under test can be various external devices or systems that communicate with the device under test. For example, when the device under test is a main control apparatus, the corresponding associated device may be a merging unit, VSC control and protection system, fire protection system, or valve cooling system. When the device under test is an expansion chassis, the corresponding associated device may be a submodule system. When the device under test is a submodule controller, the corresponding associated device may be an energy storage valve control system, battery control system, isolation switch, bypass switch, and IGBT.

In the embodiments of the present application, after receiving the test indication information, the testing device may further interpret the test indication information to extract indication information, a test task, a test parameter, a test case, test scripts, a state sequence, an operating parameter, and the like from the test indication information; determine the test type based on the indication of the indication information; and determine, based on the indication of the indication information, the device under test in the energy storage control system that needs to be tested. Specifically, the testing device may identify the device under test based on the device identifier extracted from the indication information. Subsequently, the associated device is determined based on the identified device under test. In some embodiments, after determining the device under test, the testing device may send a data request to the device under test to obtain configuration information or configuration file of the device under test. The device under test then feeds back its configuration information or configuration file to the testing device. The testing device may use the device type or device identifier of the device under test to look up the associated device connected to the device under test and configuration information of the associated device in the configuration information or configuration file. The testing device may then determine the simulation associated parameter based on the configuration information of the associated device. In some embodiments, after the testing device determines the device under test, the testing device may further obtain a preset point configuration table sent by a host computer or other devices, and look up the associated device connected to the device under test and the configuration information of the associated device in the preset point configuration table based on the device identifier of the device under test. The testing device may then determine the simulation associated parameter based on the configuration information of the associated device. In some embodiments, the test indication information also includes user-defined configuration information for the associated device. Specifically, the user can predetermine the configuration information of the associated device related to the device under test based on the test requirements and the configuration information of the device under test, and include the configuration information of the associated device in the test indication information to the testing device. Upon receiving the test indication information, based on the configuration information of the associated device included in the test indication information, the testing device may directly simulate the associated device connected to the device under test, and determine the simulation associated parameter.

S203. Test the device under test based on the simulation associated parameter and the test indication information, and receive a test result of the device under test.

In the embodiments of the present application, the testing device is installed with testing software, and the testing software can simulate any device in the energy storage control system. For example, the testing device may be installed with logic control software, and the logic control software can be used to implement any function of any device in the energy storage control system through program code. By executing the program code, communication or data interaction between the simulated device and the device under test is achieved to complete functional testing. As another example, the testing device may be installed with interface configuration software, and the interface configuration software can be used to implement any interface implementation of any device in the energy storage control system through program code. By executing the program code, communication or data interaction between the simulated device and the device under test is achieved to complete interface testing. During specific testing, the testing device parses the test indication information to extract a test task, a test case, test scripts, a state sequence, a test parameter, an operating parameter, or indication information from the test indication information; determines the device under test and associated device based on the indication of the indication information; and determines some configuration parameters and implementation parameters for simulating the associated device. That is, after the simulation associated parameter is determined, communication with the device under test can be performed through the device simulated based on the simulation associated parameter, thereby achieving test data interaction to complete the testing. In this testing process, if interface type testing is implemented, the test parameter is transmitted between the interface simulated by the simulation interface parameter and the corresponding interface of the device under test to achieve testing. If functional type testing is implemented, an operating parameter is transmitted between the functional module simulated by the simulation functional parameter and the device under test to achieve testing. It should be noted that if the simulation associated parameter is a simulation interface parameter, the testing modules of the testing device that implement various interface functions support custom configuration of interface implementation. General and proprietary protocols such as high-speed serial communication protocols, Ethernet protocols, and Aurora protocols can be set through the host computer software or the testing software on the testing device. If the simulation associated parameter is a simulation functional parameter, the testing modules of the testing device that implement various functions support custom configuration of functional implementation, and the test logic of functions can be custom-edited or modified. After the testing device completes the testing of the device under test, the device under test feeds back the test result to the testing device, and the testing device may receive the test result.

In some embodiments, after receiving the test result, the testing device may directly report the test result to the host computer to instruct the host computer to display the test result to users for analysis or to instruct the host computer to perform statistical analysis on the test result. In some embodiments, after the testing device receives the test result, the testing device may also analyze the test result to determine whether other task testing needs to be performed; and continues to trigger testing if it is determined that other task testing is needed. That is, communication with the energy storage control system is performed based on the indication of the test indication information until all testing is completed, achieving fully automated multi-task testing.

The testing method for energy storage valve control described in the embodiments of the present application involves receiving the test indication information, based on the test indication information, simulating the associated device connected to the device under test in the energy storage control system, determining the simulation associated parameter, testing the device under test based on the simulation associated parameter and the test indication information, and receiving the test result of the device under test. In the above testing method, the testing device may simulate any device associated with the device under test in the energy storage control system, specifically by simulating the interface implementation and functional execution logic implementation of any device; and achieve the above simulated interface implementation or functional implementation through the simulation associated parameter. This enables the testing method to perform data interaction with the device under test via the simulated interface implementation or functional logic implementation to complete the testing. Therefore, the testing process is not limited to testing a specific type of device under test and can achieve various types of testing, such as interface testing of the device under test or functional testing of the device under test, thereby improving the applicability of the testing method to some extent.

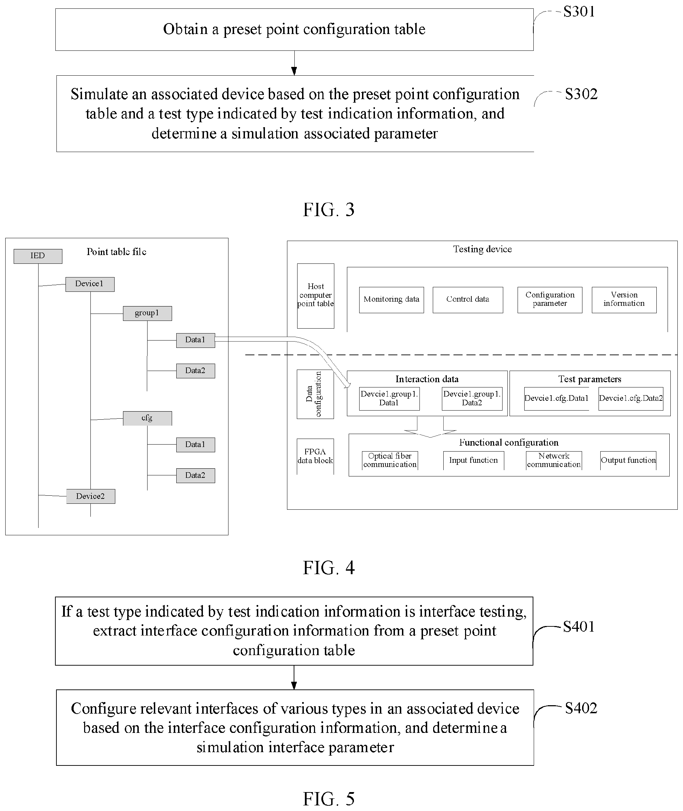

In one embodiment, a method for conducting a test based on a test instruction is provided. Specifically, when executing S202 "Simulate an associated device connected to the device under test in the energy storage control system based on the test indication information to obtain a simulation associated parameter," as shown in Figure 3, the testing device specifically executes the step.

S301. Obtain the preset point configuration table.

The preset point configuration table includes actual interaction data of hardware interfaces, internal parameters of each testing module, configuration information of each testing module, interface parameters of each testing module, test parameters of each test task, test logic of each functional module, and configuration information of each functional module. Specifically, the preset point configuration table may include monitoring data, control data, configuration parameters, version information, interaction data, test parameters, functional configuration parameters, test logic, and test code of the testing device. The functional configuration parameters include relevant functional parameters for optical fiber communication, relevant functional parameters for input functions, relevant functional parameters for network communication, and relevant functional parameters for output functions. The test logic includes test logic for relevant functions of pipe limit communication, test logic for relevant functions of input functions, test logic for relevant functions of network communication, and test logic for relevant functions of output functions. The preset point configuration table can be obtained by configuring a point table by the host computer. In some embodiments, the preset point configuration table can have a tree structure (see the schematic diagram in FIG. 4), with the root node being IED, which can connect to multiple testing modules, such as Device1 and Device2. A testing module may include two types of groupings: one grouping is for actual interaction data groups of hardware interfaces, which can be divided into multiple groups based on the number of hardware interfaces, such as group1 and group2 interfaces. This grouping generally includes configuration information such as board number, channel number, and communication rate. The other grouping for test parameters is fixed as cfg, with its child nodes being internal parameters of the testing module, related to test tasks and also related to the test logic of functional modules. Each grouping contains business interaction data, such as Data1 and Data2. The transmitted data are corresponding references in the preset point configuration table, and the references are used to identify path information of the tree structure information. For example, Device1.group1.Data1 represents data 1 of group 1 of testing module 1.

In some embodiments, the testing device may receive a preset point configuration table sent by the host computer or other devices. The preset point configuration table includes interface configuration information for at least one type of relevant interface and functional configuration information for at least one type of functional module. Each piece of interface configuration information includes the operating parameter of the corresponding interface, and each piece of functional configuration information includes test logic of the corresponding functional module.

In the embodiments of the present application, the host computer or other devices can configure a point table to obtain the preset point configuration table. After the point configuration table is configured, it can be directly transmitted to the testing device through configuration software on the host computer or other devices to ensure consistency of the configuration file. The testing device may store the preset point configuration table after receiving it. When receiving a test instruction, the testing device may extract the preset point configuration table from the storage space to look up configuration information of the associated device of the device under test. Subsequently, the testing device may determine the simulation associated parameter based on the configuration information of the associated device and configure the testing module on the testing device based on the simulation associated parameter, enabling the testing module to implement the same functions as the associated device, thereby facilitating subsequent communication testing with the device under test based on the testing module. For example, the testing device may parse the configuration information of the associated device, configure various grouping information of the corresponding testing module in the point configuration table to each hardware board of the testing device, achieving binding of service information data to registers. During the configuration process, if it is found that the information in the preset point configuration table does not correspond to the actual hardware, the configuration of the testing module based on the configuration information in the preset point configuration table is stopped, and a fault code is sent to the host computer for testing personnel to identify the cause of the issue based on the fault code. The embodiments of the present application obtain the configuration information of the associated device through the point configuration table, enabling rapid configuration, thereby improving testing efficiency.

S302. Simulate the associated device based on the preset point configuration table and a test type indicated by the test indication information, and determine the simulation associated parameter.

In the embodiments of the present application, after receiving the test indication information, the testing device may further interpret the test indication information to extract indication information, a test task, a test parameter, a test case, test scripts, a state sequence, and an operating parameter from the test indication information. The test type is determined based on the indication of the indication information, and the device under test in the energy storage control system that needs to be tested is determined based on the indication of the indication information. Specifically, the testing device may extract a device identifier from the indication information to identify the device under test. Then, correspondingly, the associated device is found based on the determined device under test. In some embodiments, the testing device may also look up the associated device communicatively connected to the device under test in the preset point configuration table based on the device identifier of the device under test. In some embodiments, after the testing device identifies the associated device, it can further extract configuration information related to the associated device from the preset point configuration table, determine a simulation associated parameter based on the configuration information, and configure the testing module on the local device based on the simulation associated parameter, so as to enable the testing module to simulate various interface implementations or functional implementations of the associated device of the device under test.

The method described in the embodiments of the present application configures the associated device using the preset point configuration table, enabling the simulation of any type of associated device connected to the device under test on the local device. By switching any type of simulation associated parameter, information exchange is implemented between the testing module and the device under test, to achieve various types of testing. This testing process does not require testing based on the device under test and the actual associated device, simplifying the physical machines required for testing to some extent, especially for multiple types of testing. Additionally, the testing device itself occupies less space, eliminating the need for a large layout of physical machines and being unrestricted by environmental constraints, thereby enhancing the applicability of the method to some extent.

In one embodiment, in the case where the simulation associated parameter is a simulation interface parameter, an implementation for determining the simulation interface parameter as a simulation associated parameter is provided, and as shown in FIG. 5, the method includes the following steps.

S401. If the test type indicated by the test indication information is interface testing, extract interface configuration information from the preset point configuration table.

S402. Configure relevant interfaces of various types in the associated device based on the interface configuration information, and determine the simulation interface parameter.

The preset point configuration table includes interface configuration information and interface configuration parameters for various types of interfaces on any device in the energy storage control system.

The embodiments of the present application relate to the case where the simulation associated parameter is a simulation interface parameter. Based on this, when receiving the test indication information, the testing device can extract indication information from it and determine the test type based on the indication information. If the test type is interface testing, it indicates that relevant interfaces of the device under test need to be tested. In this case, the testing device obtains the preset point configuration table and looks up the associated device connected to the device under test in it; after identifying the associated device, can further determine various types of relevant interfaces on the associated device that interface with the device under test; then extracts interface configuration information and interface configuration parameters for the various types of relevant interfaces interfacing with the device under test from the preset point configuration table; determines the simulation interface parameter based on the interface configuration information and interface configuration parameters of each type of interface; and configures a corresponding implementation interface on the local device based on the simulation interface parameter (that is, configuring a corresponding testing module to implement any type of interface).

The method described in the embodiments of the present application configures relevant interfaces of various types of the associated device by using the preset point configuration table, enabling the simulation of any type of interface on the local device. By switching any type of simulation interface parameter, information exchange between the testing interface and the corresponding interface of the device under test is implemented, to achieve various types of interface testing. This testing process does not require testing based on the actual interface of the device under test and the actual interface of the associated device, thereby improving the applicability of the method to some extent.

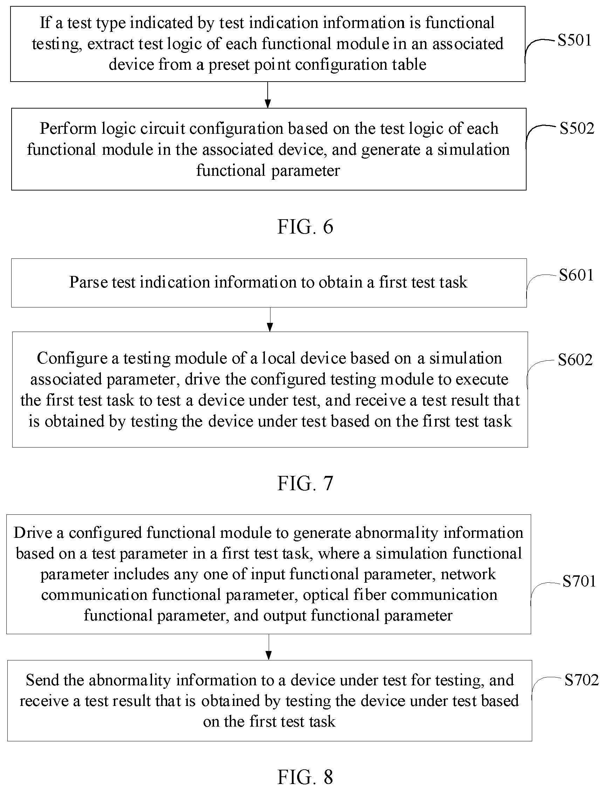

In one embodiment, in the case where the simulation associated parameter is a simulation functional parameter, an implementation for the simulation associated parameter is provided, and as shown in FIG. 6, the method includes the following steps.

S501. If the test type indicated by the test indication information is functional testing, extract test logic of each functional module in the associated device from the preset point configuration table.

S502. Perform logic circuit configuration based on the test logic of each functional module in the associated device to generate the simulation functional parameter.

The preset point configuration table includes functional configuration information for implementing each function, a functional configuration parameter (that is, operating parameter), and test logic of each functional module on any device in the energy storage control system.

The embodiments of the present application relate to the case where the simulation associated parameter is a simulation functional parameter. Based on this, when receiving the test indication information, the testing device can extract indication information from it and determine the test type based on the indication information. If the test type is functional testing, it indicates that each function or the implementation logic of each function of the device under test needs to be tested. In this case, the testing device obtains the preset point configuration table and looks up the associated device connected to the device under test in it; after identifying the associated device, can further determine functional modules or functional logic on the associated device that interface with the device under test to implement various functions; then extracts test logic, functional configuration information, and a functional configuration parameters for various functional modules interfacing with the device under test from the preset point configuration table; determines the simulation functional parameter based on the test logic, functional configuration information, and functional configuration parameters of various functional modules; and configures a corresponding functional module on the local device based on the simulation functional parameter (that is, configuring a corresponding testing module to implement any type of functional module).

The method described in the embodiments of the present application configures each functional module in the associated device by using the preset point configuration table, enabling the simulation of test logic for each function on the local device. Specifically, a testing module is configured on the local device to simulate the corresponding functional implementation of the associated device. Through the functional module implemented by the simulation functional parameter, information interaction with the device under test is performed to achieve corresponding functional testing. This testing method can test the correctness of the execution logic of each function implemented on the device under test, thereby enabling testing of software processes.

In one embodiment, the testing device is equipped with multiple testing modules, and the testing modules can be configured based on the simulation associated parameter determined from the configuration information of the associated device, enabling the configured testing modules to implement functions similar to those of the associated device. Subsequently, the configured testing modules can be used to test the device under test based on the test indication information to obtain a test result.

Different testing modules can implement different functions through configuration. For example, a testing module can implement the functions of a battery management controller, a testing module can implement the functions of a submodule controller, or a testing module can implement various interface functions in a valve control protection system.

In the embodiments of the present application, when determining the associated device of the device under test, the testing device can further obtain configuration information of the associated device from a point configuration table or configuration table, generate a simulation associated parameter based on the configuration information of the associated device, and configure a testing module on the testing device based on the simulation associated parameter. In some embodiments, when the associated device is a single device, a corresponding testing module on the testing device may be configured. In some embodiments, when the associated device includes multiple devices, a corresponding number of testing modules on the testing device may be configured correspondingly, enabling one or more configured testing modules to simulate the associated device of the device under test for communication testing with the device under test. During specific testing, the configured testing module can communicate with the device under test in the energy storage valve control and protection system based on the indication of the test task or based on the test parameter, thereby achieving test data interaction to complete the testing. Various communication interfaces of the testing module on the device under test support custom configuration, and general and proprietary protocols such as high-speed serial communication protocols, Ethernet protocols, and Aurora protocols can be set through corresponding software.

In the testing method described in the embodiments of the present application, the testing device simulates associated devices of different devices under test by configuring different testing modules, achieving communication testing with various devices under test. This enables testing of any device in the energy storage control system and any test item, thereby improving the comprehensiveness of testing to some extent.

In one embodiment, an implementation for S203 is provided. That is, S203 of "Test the device under test based on the simulation associated parameter and the test indication information, and receive a test result of the device under test," as shown in FIG. 7, includes:
S601. Parse the test indication information to obtain a first test task.

The first test task may be a fault test task, an interface function test task, or a state detection task. The first test task includes a test case, a test parameter, an operating parameter, test logic, or the like.

In the embodiments of the present application, after receiving the test indication information, the testing device may further parse the test indication information to extract the first test task from the test indication information. The first test task may be a single test task corresponding to a test item or multiple test subtasks corresponding to a test item. In a case of multiple test subtasks, they can be continuously executed test subtasks or non-continuously executed test subtasks. For example, the multiple test subtasks can be continuous tasks for fault testing, continuous tasks for interface function testing, or continuous tasks for state detection.

S602. Configure a testing module of a local device based on the simulation associated parameter, drive the configured testing module to execute the first test task to test the device under test, and receive a test result that is obtained by testing the device under test based on the first test task.

In the embodiments of the present application, when the testing device determines the simulation associated parameter, since the simulation associated parameter includes some implementation parameters for various types of interfaces corresponding to the device under test on the associated device, and implementation parameters for various types of functions corresponding to the device under test on the associated device, the testing device may configure any testing module on the local device based on the simulation associated parameter, enabling the configured testing module to implement various types of interfaces or various types of functions.

In the embodiments of the present application, after the testing device parses the first test task, it can establish a communication connection with the device under test based on the indication of the first test task, and achieve testing of the device under test by transmitting the test parameter between the configured testing module and the device under test, so as to obtain a test result corresponding to the first test task. When the first test task includes multiple test subtasks, during specific testing, the testing device may sequentially test the device under test based on the multiple test subtasks, that is, repeatedly transmitting the test parameters from different test subtasks between the configured testing module and the device under test to achieve testing of the device under test, so as to obtain a test result corresponding to each test subtask. In some embodiments, the testing device may alternatively simultaneously test the device under test based on all test subtasks to obtain a test result corresponding to each test subtask.

The testing method provided in the embodiments of the present application only requires issuing test indication information to the testing device. The testing device may automatically parse the test indication information to obtain the test task and automatically simulate any associated device to complete the testing, thereby achieving a fully automated testing method for the energy storage control system.

In one embodiment, when the simulation associated parameter includes a simulation functional parameter and the corresponding testing module includes a functional module, that is, when executing the above S602 "Drive the configured testing module to execute the first test task to test the device under test, and receive a test result that is obtained by testing the device under test based on the first test task," as shown in FIG. 8, the testing device specifically executes the step:
S701. Drive the configured functional module to generate abnormality information based on a test parameter in the first test task; where the simulation functional parameter includes any one of input functional parameter, network communication functional parameter, optical fiber communication functional parameter, and output functional parameter.

The abnormality information may include an abnormal message. The type of abnormality information is determined based on the type of the simulation functional parameter. For example, if the simulation functional parameter is an input functional parameter, the abnormality information may be determined as abnormal input information. If the simulation functional parameter is an output functional parameter, the abnormality information may be determined as abnormal output information. If the simulation functional parameter is a network communication functional parameter, the abnormality information may be determined as abnormal network information. If the simulation functional parameter is an optical fiber communication functional parameter, the abnormality information may be determined as abnormal optical fiber information.

In the embodiments of the present application, when the testing device determines that the simulation associated parameter is a simulation functional parameter and extracts the first test task from the test indication information, it can further extract test cases, test parameters, operating parameters test logic from the first test task; directly executes the first test task based on these extracted parameters, test cases, or test logic; and generates abnormality information corresponding to the simulation functional parameter in combination with the type of the simulation functional parameter.

S702. Send the abnormality information to the device under test for testing, and receive a test result that is obtained by testing the device under test based on the first test task.

In the embodiments of the present application, after the testing device generates the abnormality information, it can start the configured functional module to send the abnormality information to the device under test. The device under test validates or verifies the content of the abnormality information or validates or verifies the operation logic of the abnormality information, obtains a test result based on the validation or verification result, and feeds back the test result to the testing device.

In some embodiments, when the abnormality information includes an abnormal message, a short-term fault insertion testing function can be implemented. Specifically, when the testing device executes the step S701, the specific execution step is: sending the abnormal message to the device under test for testing according to a preset sending cycle, and receiving the test result that is obtained by testing the device under test based on the first test task. The preset sending cycle can be pre-set and can be one communication cycle or two communication cycles.

In the embodiments of the present application, when the testing module executes the first test task and generates the abnormal message, for example, it can generate an abnormal message with an incorrect message start symbol. In some embodiments, the testing module can drive a field programmable gate array (Field Programmable Gate Array, FPGA) to generate the abnormal message. Before specific testing, some simple test programs can be pre-developed in the FPGA. Logic control is performed through internal parameters of the testing device, and the host computer can control the execution of the test programs by modifying the internal parameters of the testing device.

In the embodiments of the present application, when the testing device generates the abnormal message, it can send the abnormal message according to a preset sending cycle and set a resume occasion, for example, resuming after sending the abnormal message for one communication cycle. When receiving the abnormal message, the device under test can check whether its own message sending logic is consistent with the preset sending cycle and resume occasion of the abnormal message set by the testing module. If consistent, the test passes; and if inconsistent, the test fails. The test result is obtained. The test result can be returned to the testing device. It should be noted that after driving the FPGA to generate the abnormal message, the abnormal message can be sent to the device under test according to the preset sending cycle and resume occasion. Since the FPGA can achieve microsecond-level sending speed, generating and sending the abnormal message through the FPGA can achieve microsecond-level fault testing. It should be noted that the device under test in this embodiment may be a submodule controller.

The method described in the embodiments of the present application implements a short-term fault insertion testing function. By simulation to generate the abnormal message for testing, the testing can be refined to simulate abnormalities such as cyclic redundancy check (Cyclic Redundancy Check, CRC) and frame loss at high-speed communication interfaces, as well as simulate faults with durations at the microsecond level.

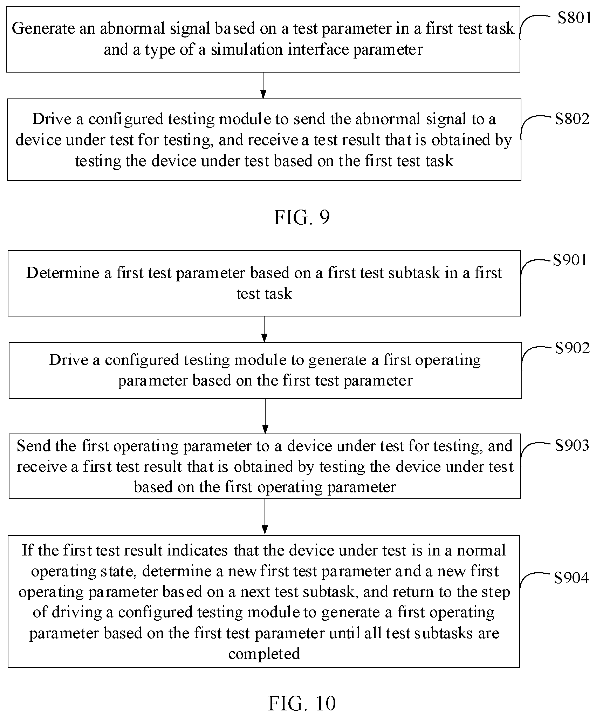

In one embodiment, when the simulation associated parameter includes a simulation interface parameter, that is, when executing the above S602 "Drive the configured testing module to execute the first test task to test the device under test, and receive a test result that is obtained by testing the device under test based on the first test task," as shown in FIG. 9, the testing device specifically executes the step:
S801. Generate an abnormal signal based on a test parameter in the first test task and a type of the simulation interface parameter.

The type of abnormal signal is determined based on the type of the simulation interface parameter. For example, if the simulation interface parameter is optical fiber interface parameters, the abnormal signal may be determined as an abnormal optical fiber signal. If the simulation interface parameter is a network interface parameter, the abnormal signal may be determined as an abnormal network signal.

In the embodiments of the present application, when the testing device determines that the simulation associated parameter is a simulation interface parameter and extracts the first test task from the test indication information, it can further extract a test case, a test parameter, an operating parameter, and test logic from the first test task. The first test task is directly executed based on the extracted parameter, test case, or test logic, and an abnormal signal corresponding to the simulation interface parameter is generated in combination with the test parameter in the first test task and the type of the simulation interface parameter. For example, if an optical drive signal is determined based on the type of the simulation interface parameter, the implementation of the optical drive signal can be set based on the test parameter in the first test task. If the test parameter is a signal strength value, the signal strength of the optical drive signal is set according to the signal strength value indicated by the test parameter.

In some embodiments, when the testing device generates an abnormal signal, for example, it can generate an IGBT1 drive board feedback signal with no light duration exceeding 800 microseconds, corresponding to the IGBT1 test interface. In some embodiments, the testing device may simulate an IGBT1 drive board feedback signal exceeding 800 microseconds. It should be noted that the abnormal signal may be determined based on the test parameter in the preset point configuration table or can be edited by testing personnel and issued by a lower-level computer.

S802. Drive the configured testing module to send the abnormal signal to the device under test for testing, and receive a test result that is obtained by testing the device under test based on the first test task.

In the embodiments of the present application, after the testing device generates the abnormal signal, it can send the abnormal signal to the corresponding interface of the device under test through the configured testing module. The device under test detects, validates, or verifies the abnormal signal, or validates or verifies the sending logic of the abnormal signal, and obtains a test result based on the detection, validation, or verification results, feeding back the test result to the testing device.

In some embodiments, in the embodiments of the present application, when the testing device generates an abnormal signal, it can send the abnormal signal to the device under test. When the device under test receives the abnormal signal, it can generate a fault signal based on the abnormal signal and obtain a test result. For example, if the abnormal signal is an IGBT1 drive board feedback signal with no light duration exceeding 800 microseconds, the corresponding fault signal is a valve control protection system VBC IGBT1 drive voltage secondary side fault signal. The test result is returned to the testing device. When the testing device receives the test result, it can report the test result to the host computer to display the fault state of the device under test to testing personnel. If the testing personnel find that the fault information is reported correctly, the test passes. It should be noted that the device under test in this embodiment may be a submodule controller.

Another implementation of the above testing method can be briefly described as follows: Issue fault state test indication information through the host computer. When the testing device receives the fault state test indication information, it immediately simulates an IGBT1 drive board feedback signal with no light duration exceeding 800 microseconds and sends the abnormal signal to the device under test. After receiving the abnormal signal, the device under test performs testing and reports a VBC IGBT1 drive voltage secondary side fault signal through the VBC interface. The testing device receives the fault signal sent by the device under test and reports the fault signal to the host computer. The host computer displays the fault state of the device under test, and if the testing personnel confirm that the fault information is reported correctly, the test passes.

The method described in the embodiments of the present application implements another fault insertion testing function. Through simulation to generate the abnormal signal for testing, the testing can be refined to simulate abnormalities such as cyclic redundancy check and frame loss at high-speed communication interfaces.

In one embodiment, a testing method for the testing device to execute multiple test subtasks is provided, where the first test task includes multiple test subtasks, and when executing the above S602 "Drive the configured testing module to execute the first test task to test the device under test, and receive a test result that is obtained by testing the device under test based on the first test task," as shown in FIG. 10, the testing device specifically executes the step:
S901. Determine a first test parameter based on a first test subtask in the first test task.

The multiple test subtasks in the first test task can be multiple test subtasks determined according to the sequence of execution time.

In the embodiments of the present application, after the testing device receives the test indication information, it can further parse the test indication information to extract multiple test subtasks from the test indication information. These multiple test subtasks can be multiple test subtasks corresponding to a test item, specifically continuously executed tasks or non-continuously executed tasks. For example, multiple test subtasks can be continuous tasks for fault testing, continuous tasks for interface function testing, continuous tasks for state detection, or continuous tasks for functional testing. When the testing device parses multiple test subtasks, it can first execute the first test subtask and extract the first test parameter from the first test subtask to subsequently perform testing of the test subtask based on the first test parameter.

S902. Drive the configured testing module to generate a first operating parameter based on the first test parameter.

The first operating parameter may be a signal or information set based on the first test parameter. The first operating parameter may be a signal or information transmitted between the configured testing module and the device under test.

In the embodiments of the present application, after the testing device extracts the first test parameter, it can drive or start the configured testing module to generate the first operating parameter based on the first test parameter. For example, if the simulation associated parameter is a simulation interface parameter and the first test parameter is a performance parameter of a signal sent by the configured testing module, such as signal strength or signal cycle, the first operating parameter corresponding to the configured testing module can be generated based on the first test parameter.

S903. Send the first operating parameter to the device under test for testing, and receive a first test result that is obtained by testing the device under test based on the first operating parameter.

In the embodiments of the present application, after the testing device generates the first operating parameter, it can start the configured testing module to send the first operating parameter to the device under test. When the device under test receives the first operating parameter, it can validate or verify the first operating parameter, or validate or verify the operation logic of the first operating parameter, or execute the corresponding interface or functional module based on the first operating parameter, and obtain a test result based on the validation, verification, or execution results, feeding back the test result to the testing device.

S904. If the first test result indicates that the device under test is in a normal operating state, determine a new first test parameter and a new first operating parameter based on a next test subtask, and return to the step of driving the configured testing module to generate the first operating parameter based on the first test parameter until all test subtasks are completed.

The embodiments of the present application involve a cyclic testing process, that is, repeatedly executing the methods of S902 and S903 according to the execution sequence of each test subtask, for example, sequentially executing the first test subtask, the second test subtask, the second test subtask, ..., up to the Nth test subtask, until all test subtasks are completed. In some embodiments, a cycle termination condition can also be set to end the cyclic testing, such as setting a cycle count or determining that the test result corresponding to each test subtask indicates that the device under test is in an abnormal state. It should be noted that the device under test may be a submodule controller.

The method described in the embodiments of the present application implements a continuous state testing method or a continuous logic testing method. By simulating the interaction between a battery controller, a submodule controller, and a valve control protection system, the testing can be completed, thereby improving testing efficiency.

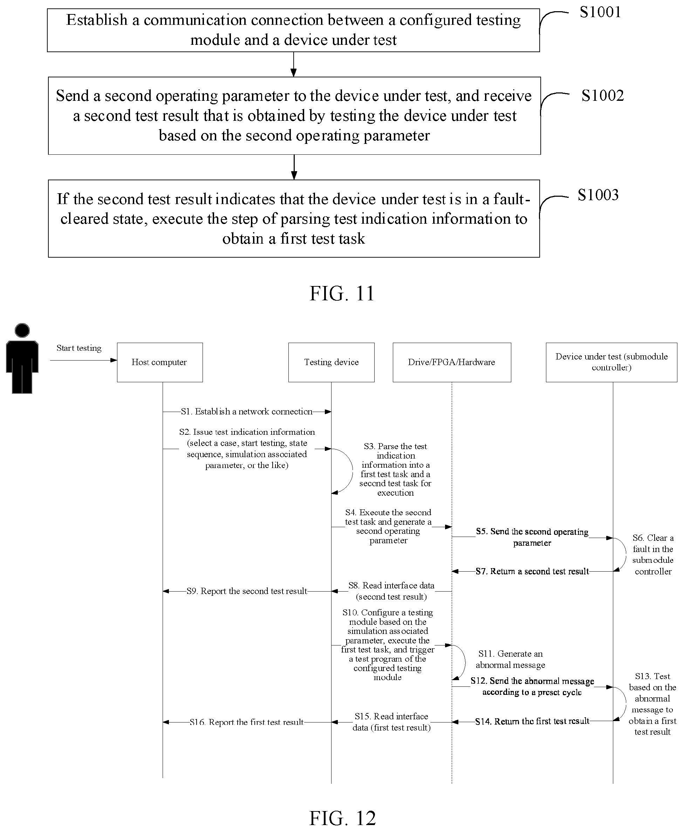

In one embodiment, before executing the first test task, as shown in FIG. 11, the testing device also needs to execute the following steps:
S1001. Establish a communication connection between the configured testing module and the device under test.

In the embodiments of the present application, the testing device may configure the testing module on the local device using configuration parameters in the preset point configuration table, enabling the testing module to simulate the functions of the associated device of the device under test or to implement the functions of the associated device of the device under test, and then establish a communication connection with the device under test for subsequent testing of the device under test. The preset point configuration table includes configuration parameters, interaction data, and functional configuration parameters of various communication modules for various types of associated device (see optical fiber communication parameters, network communication parameters, input functional parameters, and output functional parameters in FIG. 4). Therefore, the testing device determines the device under test, further determines the functional configuration parameters of each communication module of the associated device related to the device under test, determines the simulation associated parameter based on these functional configuration parameters, and configures the simulation associated device in the device under test based on the simulation associated parameter, thereby enabling the configured testing module to establish a normal communication connection with the device under test.

In some embodiments, when the testing device establishes a communication connection between the configured testing module and the device under test, it can specifically execute the steps: Extract communication protocol information from the preset point configuration table; establish the communication connection between the configured testing module and the device under test based on the communication protocol information. The preset point configuration table may include multiple types of communication protocols. The testing device may extract corresponding communication protocol information from the preset point configuration table based on the communication type or communication method of the configured testing module and the device under test, and perform communication configuration for the configured testing module and the device under test based on the communication protocol information to establish the communication connection between the configured testing module and the device under test.

S1002. Send a second operating parameter to the device under test, and receive a second test result that is obtained by testing the device under test based on the second operating parameter.

The second test result is used to indicate that the device under test is in a normal operating state or to indicate that the device under test is in an abnormal operating state.

In the embodiments of the present application, after the configured testing module establishes a communication connection with the device under test, the configured testing module or the testing device may further generate a second operating parameter based on a default test parameter in the preset point configuration table, and send the second operating parameter to the device under test. When the device under test receives the second operating parameter, it can perform a fault clearing operation based on the second operating parameter, that is, clearing all faults and alarms on the local device, to make the device under test in a normal operating state. After the device under test completes the fault clearing operation, the current operating state of the device under test is checked. If the device under test is in a normal operating state, a second test result indicating that the device under test is in a normal operating state is returned. If the device under test is in an abnormal operating state, a second test result indicating that the device under test is in an abnormal operating state is returned. In some embodiments, when receiving the second test result, the testing module can further report the second test result to the host computer, and the host computer displays the second test result so that personnel at the host computer can view the second test result in real time.

Another implementation of the above testing method can be briefly described as follows: the host computer issues test indication information; and after receiving the test indication information, the testing device communicates with the device under test based on default parameters in the preset point configuration table and sends the second operating parameter. When the device under test receives the second operating parameter, it performs fault and alarm clearing operations and returns the second test result. After receiving the second test result, the testing device reports it. The host computer displays the second test result sent by the device under test.

S1003. If the second test result indicates that the device under test is in a fault-cleared state, execute the step of parsing the test indication information to obtain a first test task.

In the embodiments of the present application, when the testing device receives the second test result returned by the device under test, if the second test result indicates that the device under test is in a normal operating state, the testing device may proceed to execute the first test task. Specifically, it can update the test parameter in the preset point configuration table, send a new test parameter to the device under test for testing the device under test, and receive the first test result returned by the device under test. The new test parameter can be some parameters required for various fault detections, which may be preconfigured in the preset point configuration table or set during fault testing based on the testing requirements of different types of devices under test. In some embodiments, when receiving the second test result, the testing device may also report the second test result to the host computer, and the host computer then displays the second test result, allowing personnel at the host computer to view the second test result corresponding to the second test task in real time.

The embodiments of the present application implement a fault detection method, where fault detection can be completed based on multiple interaction steps, thereby achieving an automated fault detection method.

In some embodiments, based on the testing method described in the above embodiments, an example description of the process of the above method is provided. As shown in FIG. 12, the process includes: S1. Establish a network connection. S2. Issue test indication information (select a case, start testing, state sequence, simulation associated parameter, or the like). S3. Parse the test indication information into a second test task and a first test task for execution. S4. Execute the second test task to generate a second operating parameter. S5. Send the second operating parameter. S6. Clear faults in a submodule controller. S7. Return the second test result. S8. Read interface data (second test result). S9. Report the second test result. S10. Configure a testing module based on the simulation associated parameter, execute the first test task, and trigger a test program of the configured testing module. S11. Generate an abnormal message. S12. Send the abnormal message according to a preset cycle. S13. Test based on the abnormal message to obtain a first test result. S14. Return the first test result. S15. Read interface data (first test result). S16. Report the first test result.

Another implementation of the above testing method can be briefly described as follows: Issue fault test indication information through a fault state interface of the host computer. After receiving the test indication information, the testing device immediately generates an abnormal message indicating a message start symbol error and simulates a message sending manner of the valve control system (resume after one communication cycle). When receiving the abnormal message, the device under test returns a fault test result. The testing device receives the fault test result and reports the test result to the host computer. The host computer displays the fault state of the device under test, and if the testing personnel confirm that no fault is reported, the test passes.

In one embodiment, the first test task may include two test subtasks, that is, a first test subtask and a second test subtask. Specifically, when executing the first test subtask, the testing device may specifically execute the steps: establishing a communication connection with the device under test based on the first test subtask, sending a first test parameter to the device under test, and receiving a first test result returned by the device under test, where the first test result is a result returned by the device under test after performing a fault clearing operation based on the first test parameter; and if the first test result indicates that the device under test is in a normal operating state, testing the device under test based on the second test subtask to obtain a second test result corresponding to the second test subtask. The embodiments of the present application implement a fault detection method, where fault detection can be completed based on two test tasks, thereby achieving an automated fault detection method.

In some embodiments, when executing the step "Test the device under test based on the second test subtask to obtain a second test result corresponding to the second test subtask," the testing device specifically executes the steps: generating an abnormal message based on the second test subtask; and sending the abnormal message to the device under test for testing according to a preset sending cycle to obtain the second test result corresponding to the second test subtask.

In some embodiments, the testing device may also execute the steps: generating an abnormal signal based on the second test subtask; and sending the abnormal signal to the device under test for testing, to obtain the second test result corresponding to the second test subtask. The method described in the embodiments of the present application implements another fault insertion testing function. Through simulation to generate the abnormal signal for testing, the testing can be refined to simulate abnormalities such as cyclic redundancy check and frame loss at high-speed communication interfaces.

In some embodiments, the testing device may also execute the steps: generating a battery voltage signal based on the second test subtask; sending the battery voltage signal to the device under test for testing through a first interface, and receiving, through a second interface, the second test result that is corresponding to the second test subtask and that is returned by the device under test.

In the embodiments of the present application, when the testing module executes the second test subtask and determines that the second test subtask indicates a pass-through state test, a battery voltage signal can be generated. For example, a "system voltage" of 1000V for a battery management controller BMC can be generated. In some embodiments, the battery voltage signal may be determined by updating the test parameter in the point configuration table by the testing module or can be edited by testing personnel and issued by a lower-level computer.

The first interface and the second interface are interfaces of different modules. For example, the first interface is a BMC interface simulated by the testing module, and the second interface is a VBC interface on the device under test. The device under test in this embodiment may be a submodule controller.

In the embodiments of the present application, when the testing device generates a battery voltage signal, it can send the battery voltage signal to the device under test through the first interface (an interface implemented by the simulation interface parameter). The device under test can receive the battery voltage signal through an interface of the same type as the first interface (the interface implemented by the simulation interface parameter). For example, if the first interface is a BMC interface, the device under test receives the battery voltage signal through a BMC interface and then immediately forwards the battery voltage signal to the second interface (for example, a VBC interface). The second interface returns the battery voltage signal to the testing device. The testing device may receive the battery voltage signal through a second interface (an interface implemented by the simulation interface parameter) (for example, a VBC interface) and further determine whether the received battery voltage signal is consistent with the configured battery voltage signal. If consistent, the test passes; and if inconsistent, the test fails. In some embodiments, the testing device may further report the received battery voltage signal to the host computer to display the battery voltage signal to testing personnel. The host computer can display the battery voltage signal so that testing personnel can compare and determine the test result.

Another implementation of the above testing method can be briefly described as follows: the test parameter is modified through the fault state interface of the host computer, for example, modifying the test parameter "system voltage" of BMC to 1000V and send it to the testing device. The testing device sends a signal indicating "system voltage" of 1000V to the device under test through the BMC interface. After receiving it through the BMC interface, the device under test immediately forwards it to the VBC interface. The testing device receives, through the VBC interface, the signal indicating "system voltage" of 1000V sent by the device under test and reports it to the host computer. The host computer displays "system voltage" of 1000V on the VBC display interface, and if the testing personnel confirm that the two are consistent, the test passes.

The method described in the embodiments of the present application implements a test for a pass-through function for different interfaces. The test is performed by simulating an interface of a battery controller and an interface of a valve control protection system. The test is achieved through simulating an associated device (the battery controller and valve control protection system) of a submodule controller, thereby improving testing efficiency.

Based on the above embodiments, a continuous state testing method or continuous logic testing method is further provided, where the testing method requires multiple test subtasks to be implemented. Specifically, the above second test subtask includes multiple test subtasks. When executing the step "Test the device under test based on the second test subtask to obtain a second test result corresponding to the second test subtask," the testing device specifically executes the steps: determining a second test parameter based on a first test subtask in the second test subtask; sending the second test parameter to the device under test to obtain a third test result; where the third test result is used to indicate that the device under test is in a normal operating state or to indicate that the device under test is in an abnormal operating state; if the third test result indicates that the device under test is in a normal operating state, determining a new second test parameter based on a next test subtask; and returning to the step of sending the second test parameter to the device under test until all test subtasks are completed.

In the embodiments of the present application, the testing device may update the test parameter in the point configuration table to generate the second test parameter. The second test parameter may include parameters required for various state detections or continuous logic detections, which may be preconfigured in the point configuration table or set during various state tests or continuous logic tests based on the testing requirements of different types of devices under test.

In the embodiments of the present application, after the testing module determines the second test parameter, the testing module can send the second test parameter to the device under test. When the device under test receives the second test parameter, it can perform corresponding state detection or continuous logic detection based on the second test parameter, making the device under test operate according to preset logic or normal workflow. After the device under test completes the state detection or continuous logic detection, the current operating state of the device under test is checked. If the device under test is in a normal operating state, that is, it conforms to the preset logic or normal workflow, a third test result indicating that the device under test is in a normal operating state is returned. If the device under test is in an abnormal operating state, that is, it does not conform to the preset logic or normal workflow, a third test result indicating that the device under test is in an abnormal operating state is returned. In some embodiments, when the testing module receives the third test result, it can also report the third test result to the host computer, and the host computer displays the third test result so that personnel at the host computer can view the first test result corresponding to the first test subtask in real time.

The embodiments of the present application involve a cyclic testing process, that is, repeatedly executing the testing steps according to the execution sequence of each test subtask, for example, sequentially executing the first test subtask, the second test subtask, the second test subtask, ..., up to the Nth test subtask, until all test subtasks are completed. In some embodiments, a cycling termination condition can also be set to end the cyclic testing, such as setting a cycling count or the test result corresponding to each test subtask indicating that the device under test is in an abnormal state. It should be noted that the device under test may be a submodule controller.

The method described in the embodiments of the present application implements a continuous state testing method or a continuous logic testing method. By simulating the interaction between a battery controller, a submodule controller, and a valve control protection system, the testing can be completed, thereby improving testing efficiency.

In one embodiment, another method for state detection or continuous logic detection is provided, where the above second test subtask includes a third test subtask, a fourth test subtask, and a fifth test subtask. When executing the step "Test the device under test based on the second test subtask to obtain a second test result corresponding to the second test subtask," the testing device specifically executes the following steps:
K1: Generate a battery fault parameter based on the third test subtask.

The battery fault parameter can indicate a battery fault level. For example, the battery fault parameter is "battery module level 5 fault."

In the embodiments of the present application, when executing the first test subtask and determines that the first test subtask indicates a battery fault state test or battery operation logic detection, the testing device may generate the battery fault parameter, for example, generating a "battery module level 5 fault" for BMC.

K2: Send the battery fault parameter to the device under test to obtain a fourth test result corresponding to the third test subtask.

In the embodiments of the present application, when generating the battery fault parameter, the testing device may send the battery fault parameter to the device under test. After receiving the battery fault parameter, the device under test can perform pass-through of the battery fault parameter through different interfaces to obtain the fourth test result and return the fourth test result to the testing module. The fourth test result includes the battery fault parameter after pass-through. In some embodiments, the testing device may also report the fourth test result to the host computer so that testing personnel can view the fourth test result corresponding to the first test subtask.

K3: If the fourth test result indicates that the device under test is in a normal operating state, send a bypass instruction to the device under test based on the fourth test subtask to obtain a fifth test result corresponding to the fourth test subtask.

In the embodiments of the present application, when receiving the fourth test result and determining that the fourth test result indicates that the device under test is in a normal operating state, the testing device may generate a bypass instruction based on the indication of the second test subtask and send the bypass instruction to the device under test. After receiving the bypass instruction, the device under test can further perform a corresponding bypass detection operation based on the bypass instruction to obtain the fifth test result and return the fifth test result to the testing module. In some embodiments, the testing module can also report the fifth test result to the host computer so that testing personnel can view the fifth test result corresponding to the second test subtask.

K4: If the fifth test result indicates that the device under test is in a normal operating state, send a switch closing signal to the device under test based on the fifth test subtask to obtain a sixth test result corresponding to the fifth test subtask.

In the embodiments of the present application, when receiving the fifth test result and determining that the fifth test result indicates that the device under test is in a normal operating state, the testing device may generate the switch closing signal based on the indication of the third test subtask and send the switch closing signal to the device under test. After receiving the switch closing signal, the device under test can further perform a corresponding switch closing detection operation based on the switch closing signal to obtain the sixth test result, and return the sixth test result to the testing module. In some embodiments, the testing device may also report the sixth test result to the host computer so that testing personnel can view the sixth test result corresponding to the third test subtask.

The method described in the embodiments of the present application completes testing by issuing multiple test subtasks, enabling a continuous state test or continuous logic test. This can achieve functional testing of complex logic during interaction between various devices in the valve control protection system, expanding the application scope of the above testing method.

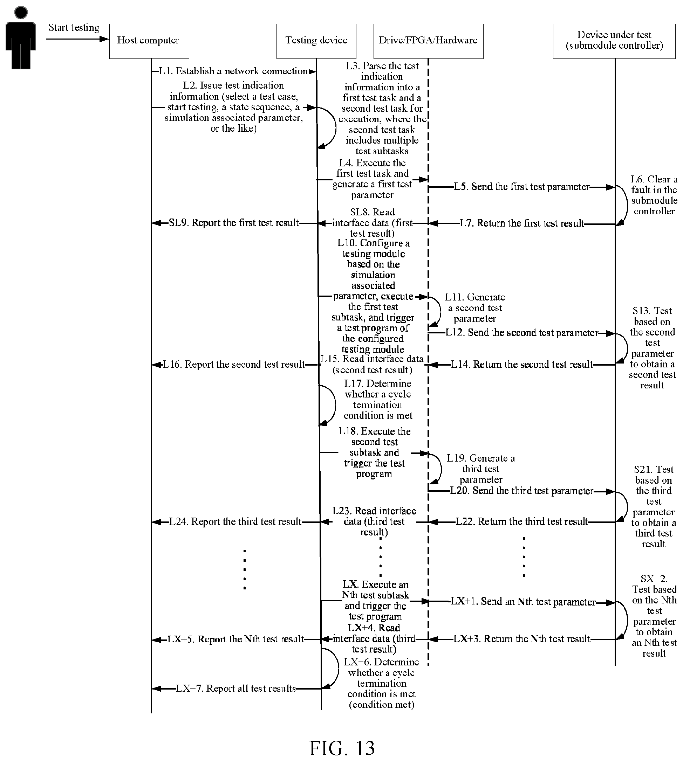

Based on the testing method described in the above embodiments, an example description of the process of the above method is provided. As shown in FIG. 13, the process includes: L1. Establish a network connection. L2. Issue test indication information (select a case, start testing, state sequence, simulation associated parameter, or the like). L3. Parse the test indication information into a first test task and a second test task for execution, where the second test task includes multiple test subtasks. L4. Execute the first test task to generate a first test parameter. L5. Send the first test parameter. L6. Clear faults in a submodule controller. L7. Return a first test result. SL8. Read interface data (first test result). SL9. Report the first test result. L10. Configure a testing module based on the simulation associated parameter, execute a first test subtask, and trigger a test program of the configured testing module. L11. Generate a second test parameter. L12. Send the second test parameter. SL13. Test based on the second test parameter to obtain a second test result. L14. Return the second test result. L15. Read interface data (second test result). L16. Report the second test result. L17. Determine whether a cycle termination condition is met. L18. Execute a second test subtask and trigger the test program. L19. Generate a third test parameter. L20. Send the third test parameter. SL21. Test based on the third test parameter to obtain a third test result. L22. Return the third test result. L23. Read interface data (third test result). L24. Report the third test result.... LX. Execute an Nth test subtask and trigger the test program. LX+1. Send an Nth test parameter. SX+2. Test based on the Nth test parameter to obtain an Nth test result. LX+3. Return the Nth test result. LX+4. Read interface data (third test result). LX+5. Report the Nth test result. LX+6. Determine whether a cycle termination condition is met (condition met). LX+7. Report all test results.

Another implementation of the above testing method can be briefly described as follows: Modify the test parameter through the fault state interface of the host computer, that is, modify the test parameter BMC "battery module level 5 fault" and send it to the testing device. The testing device sends "battery module level 5 fault" to the device under test (for example, a submodule controller) through the BMC interface. After reception through the BMC interface, the device under test immediately forwards it to the VBC interface. The testing device receives the signal of "battery module level 5 fault" sent by the device under test through the VBC interface and immediately sends a bypass instruction to the device under test. After receiving the bypass instruction through the VBC interface, the device under test immediately sends a signal to close the bypass switch. The testing device receives the bypass instruction from the device under test and immediately feeds back a bypass switch closing position signal. The device under test receives the bypass switch closing signal and immediately forwards it to the VBC interface. The testing device receives the bypass switch closing signal through the VBC interface and reports the signal to the host computer. The host computer displays "battery module level 5 fault" on the VBC display interface, with the bypass switch in the closed position. If the testing personnel confirm that the fault display ("battery module level 5 fault") and the protection action result (bypass switch closing) are correct, the test passes.

In one embodiment, in any of the methods described in the foregoing embodiments, after the testing device obtains the test result, it can also report the test result corresponding to each test task or each test subtask to the host computer.

In the method described in the embodiments of the present application, the testing device may report the test result of each test subtask or test task to the host computer, so that users of the host computer can view the test result in a timely manner, or update or modify the test parameter based on the test result, and then issue new test indication information for testing. The host computer can also be equipped with a one-click testing function, that is, setting a one-click testing control. When a user clicks or triggers the one-click testing control on the testing interface, the host computer sends test indication information to the testing device. The testing device performs testing based on the test indication information. When the test indication information indicates testing of multiple test subtasks, one-click testing can be achieved, realizing fully automated testing.

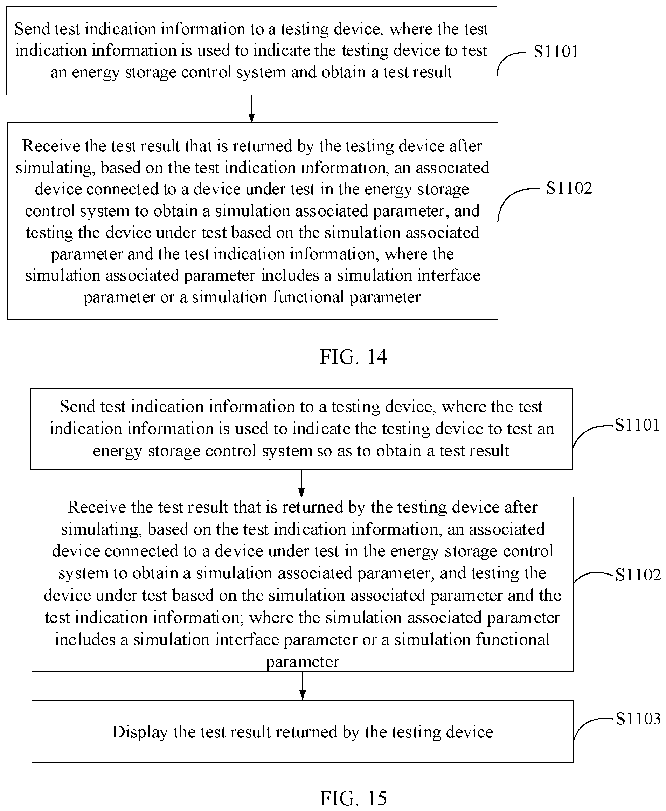

In one embodiment, a testing method for an energy storage control system on a host computer side is further provided, and the testing method is applied to the host computer in FIG. 1. As shown in FIG. 14, the testing method includes:
S1101. Send test indication information to a testing device; where the test indication information is used to instruct the testing device to test the energy storage control system to obtain a test result.
S1102. Receive the test result returned by the testing device after simulating, based on the test indication information, an associated device connected to a device under test in the energy storage control system to obtain the simulation associated parameter, and testing the device under test based on the simulation associated parameter and the test indication information; where the simulation associated parameter includes a simulation interface parameter or a simulation functional parameter.

The method described in the embodiments of the present application corresponds to the method described in the embodiment of FIG. 2. The descriptions of each step are introduced in the foregoing content. For details, reference can be made to the foregoing description, which is not repeated here.

In one embodiment, the method in FIG. 14, as shown in FIG. 15, further includes the following step.

S1103. Display the test result returned by the testing device.

The method described in the embodiments of the present application corresponds to the method described in the foregoing embodiments. The descriptions of each step are introduced in the foregoing content. For details, reference can be made to the foregoing description, which is not repeated here.

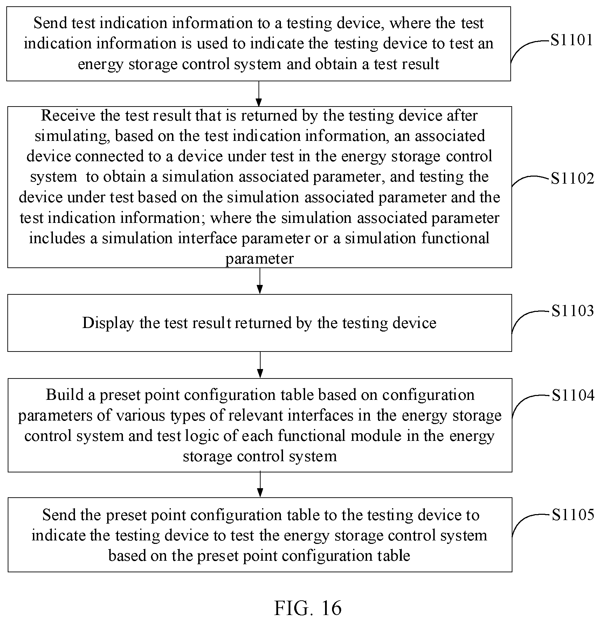

In one embodiment, the method in FIG. 14, as shown in FIG. 16, further includes the following steps.

S1104. Build a preset point configuration table based on configuration parameters of various types of relevant interfaces in the energy storage control system and test logic of each functional module in the energy storage control system.

S1105. Send the preset point configuration table to the testing device to instruct the testing device to test the energy storage control system based on the preset point configuration table.

The method described in the embodiments of the present application corresponds to the method described in the foregoing embodiments. The descriptions of each step are introduced in the foregoing content. For details, reference can be made to the foregoing description, which is not repeated here.

In one embodiment, a testing system for energy storage valve control is further provided, and the testing system includes a host computer, a testing device, and an energy storage control system. The energy storage control system includes at least a submodule controller, a main control chassis, and an expansion device. The testing device is configured to receive test indication information sent by the host computer, simulate, based on the test indication information, an associated device connected to a device under test in the energy storage control system, determine a simulation associated parameter, test the device under test based on the simulation associated parameter and the test indication information, and receive a test result of the device under test. The simulation associated parameter includes a simulation interface parameter or a simulation functional parameter. The composition of this testing system is consistent with the composition of the testing system shown in FIG. 1. For detailed structure, reference can be made to the testing system shown in FIG. 1, and the testing device may execute the testing method described in any of the embodiments of FIG. 2 to FIG. 16, which is not repeated here.

It should be understood that although the steps in the flowcharts involved in the above embodiments are displayed sequentially as indicated by arrows, these steps are not necessarily executed in the order indicated by the arrows. Unless explicitly stated herein, the execution of these steps is not strictly limited in order, and these steps can be executed in other orders. Moreover, at least some of the steps in the flowcharts involved in the above embodiments may include multiple steps or multiple stages. These steps or stages are not necessarily executed at the same time but can be executed at different times. The execution order of these steps or stages is not necessarily sequential but can be executed alternately or in rotation with other steps or at least a part of the steps or stages in other steps.

Based on the same inventive concept, the embodiments of the present application also provide a testing apparatus for energy storage control and protection to implement the testing method for energy storage control and protection described above. The implementation solution provided by the apparatus for solving problems is similar to the implementation solution recorded in the above method. Therefore, specific limitations in one or more embodiments of the testing apparatus for energy storage control and protection provided below can be referred to the limitations on the testing method for energy storage control and protection above, which are not repeated here.

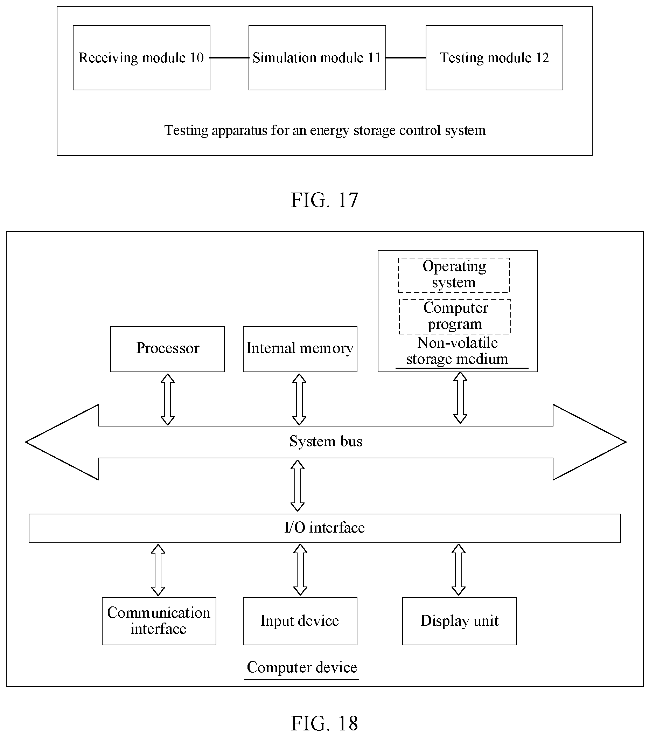

In one embodiment, as shown in FIG. 17, a testing apparatus for an energy storage control system is provided, including:
a receiving module 10 configured to receive a test instruction;
a simulation module 11 configured to simulate, based on the test instruction, an associated device in an energy storage valve control and protection system, and determine a simulation associated parameter; where the simulation associated parameter includes a simulation interface parameter or a simulation functional parameter; and
a testing module 12 configured to test the device under test based on the simulation associated parameter and the test indication information, and receive a test result of the device under test.

Each module in the above testing apparatus for energy storage control and protection can be implemented entirely or partially through software, hardware, or a combination thereof. The above modules can be embedded in or independent of a processor in a computer device in hardware form, or stored in a memory in a computer device in software form, so that the processor can call and execute operations corresponding to the above modules.

In one embodiment, a computer device is provided, which may be a server, and its internal structure diagram can be as shown in FIG. 18. The computer device includes a processor, a memory, a communication interface, a display screen, and an input apparatus connected through a system bus. The processor of the computer device is used to provide computing and control capabilities. The memory of the computer device includes a non-volatile storage medium and an internal memory. The non-volatile storage medium stores an operating system and a computer program. The internal memory provides an environment for the operation of the operating system and the computer program in the non-volatile storage medium. The communication interface of the computer device is used for wired or wireless communication with an external terminal, and wireless communication can be achieved through WIFI, mobile cellular networks, NFC (near field communication), or other technologies. The computer program, when executed by the processor, implements a testing method for energy storage control and protection. The display screen of the computer device may be a liquid crystal display or an electronic ink display, and the input apparatus of the computer device may be a touch layer covering the display screen, or keys, a trackball, or a touchpad set on the housing of the computer device, or an external keyboard, touchpad, or mouse.

Those skilled in the art can understand that the structure shown in FIG. 18 is only a block diagram of a partial structure related to the solution of the present application and does not constitute a limitation on the computer device to which the solution of the present application is applied. A specific computer device may include more or fewer components than shown in the figure, or combine certain components, or have a different arrangement of components.

In one embodiment, a computer device is provided, including a memory and a processor, where the memory stores a computer program, and when the processor executes the computer program, the following steps are implemented:
receiving test indication information;
simulating, based on the test indication information, an associated device connected to a device under test in the energy storage control system, and determining a simulation associated parameter; where the simulation associated parameter includes a simulation interface parameter or a simulation functional parameter; and
testing the device under test based on the simulation associated parameter and the test indication information, and receiving a test result of the device under test.

The computer device provided in the above embodiment has an implementation principle and technical effect similar to those of the above method embodiments, which are not repeated here.

In one embodiment, a computer-readable storage medium is provided, on which a computer program is stored, and when the computer program is executed by a processor, the following steps are implemented:
receiving test indication information;
simulating, based on the test indication information, an associated device connected to a device under test in the energy storage control system, and determining a simulation associated parameter; where the simulation associated parameter includes a simulation interface parameter or a simulation functional parameter; and
testing the device under test based on the simulation associated parameter and the test indication information, and receiving a test result of the device under test.

The computer-readable storage medium provided in the above embodiment has an implementation principle and technical effect similar to those of the above method embodiments, which are not repeated here.

Those of ordinary skill in the art can understand that all or part of the processes in the methods of the above embodiments can be implemented by instructing relevant hardware through a computer program. The computer program can be stored in a non-volatile computer-readable storage medium, and when executed, the computer program may include the processes of the embodiments of the above methods. Any reference to memory, database, or other media used in the embodiments provided in the present application may include at least one of non-volatile and volatile memory. Non-volatile memory may include read-only memory (Read-Only Memory, ROM), magnetic tape, floppy disk, flash memory, optical memory, high-density embedded non-volatile memory, resistive random access memory (ReRAM), magnetoresistive random access memory (Magnetoresistive Random Access Memory, MRAM), ferroelectric random access memory (Ferroelectric Random Access Memory, FRAM), phase change memory (Phase Change Memory, PCM), and graphene memory. The volatile memory may include a random access memory (Random Access Memory, RAM) or an external cache memory. As an illustration and not a limitation, RAM can be in various forms, such as static random access memory (Static Random Access Memory, SRAM) or dynamic random access memory (Dynamic Random Access Memory, DRAM). The databases involved in the embodiments provided in the present application may include at least one of relational databases and non-relational databases. Non-relational databases may include blockchain-based distributed databases, but are not limited to this. The processors involved in the embodiments provided in the present application may be general-purpose processors, central processing units, graphics processing units, digital signal processors, programmable logic devices, and quantum computing-based data processing logic devices, but are not limited to this.

The technical features of the above embodiments can be combined arbitrarily. To make the description concise, not all possible combinations of the technical features in the above embodiments are described. However, as long as there is no contradiction in the combination of these technical features, they should be considered within the scope recorded in this specification.

The above embodiments only express several implementations of the present application, and the descriptions are relatively specific and detailed, but they should not be understood as limiting the patent scope of the present application. It should be noted that for those of ordinary skill in the art, several deformations and improvements can be made without departing from the concept of the present application, and these belong to the protection scope of the present application. Therefore, the protection scope of the present application should be subject to the appended claims.

## Claims

1. A testing method for an energy storage control system, wherein the testing method comprises:
receiving test indication information;
simulating, based on the test indication information, an associated device connected to a device under test in the energy storage control system, and determining a simulation associated parameter; wherein the simulation associated parameter comprises a simulation interface parameter or a simulation functional parameter; and
testing the device under test based on the simulation associated parameter and the test indication information, and receiving a test result of the device under test.

2. The method according to claim 1, wherein the simulating, based on the test indication information, an associated device connected to a device under test in the energy storage control system, and determining a simulation associated parameter comprises:
obtaining a preset point configuration table; and
simulating the associated device based on the preset point configuration table and a test type indicated by the test indication information, and determining the simulation associated parameter.

3. The method according to claim 2, wherein the simulation associated parameter comprises a simulation interface parameter, and the simulating the associated device based on the preset point configuration table and a test type indicated by the test indication information, and determining the simulation associated parameter comprises:
if the test type indicated by the test indication information is interface testing, extracting interface configuration information from the preset point configuration table; and
configuring relevant interfaces of various types in the associated device based on the interface configuration information, and determining the simulation interface parameter.

4. The method according to claim 2, wherein the simulation associated parameter comprises a simulation functional parameter, and the simulating, based on a preset point configuration table and a test type indicated by the test indication information, the associated device connected to the device under test in the energy storage control system, and determining the simulation associated parameter comprises:
if the test type indicated by the test indication information is functional testing, extracting test logic of each functional module in the associated device from the preset point configuration table; and
performing logic circuit configuration based on the test logic of each functional module in the associated device to generate the simulation functional parameter.

5. The method according to any one of claims 1 to 4, wherein the obtaining a preset point configuration table comprises:
receiving the preset point configuration table; wherein the preset point configuration table comprises interface configuration information for at least one type of relevant interface and functional configuration information for at least one type of functional module, each piece of the interface configuration information comprises an operating parameter of a corresponding interface, and each piece of the functional configuration information comprises test logic of a corresponding functional module.

6. The method according to claim 1, wherein the testing the device under test based on the simulation associated parameter and the test indication information, and receiving a test result of the device under test comprises:
parsing the test indication information to obtain a first test task; and
configuring a testing module of a local device based on the simulation associated parameter, driving the configured testing module to execute the first test task to test the device under test, and receiving a test result that is obtained by testing the device under test based on the first test task.

7. The method according to claim 6, wherein the simulation associated parameter comprises a simulation functional parameter, the testing module comprises a functional module, and the driving the configured testing module to execute the first test task to test the device under test, and receiving a test result that is obtained by testing the device under test based on the first test task comprises:
driving the configured functional module to generate abnormality information based on a test parameter in the first test task; wherein the simulation functional parameter comprises any one of input functional parameter, network communication functional parameter, optical fiber communication functional parameter, and output functional parameter; and
sending the abnormality information to the device under test for testing, and receiving the test result that is obtained by testing the device under test based on the first test task.

8. The method according to claim 7, wherein the abnormality information comprises an abnormal message, and the sending the abnormality information to the device under test for testing, and receiving the test result that is obtained by testing the device under test based on the first test task comprises:
sending the abnormal message to the device under test for testing according to a preset sending cycle, and receiving the test result that is obtained by testing the device under test based on the first test task.

9. The method according to claim 6, wherein the simulation associated parameter comprises a simulation interface parameter, and the driving the configured testing module to execute the first test task to test the device under test, and receiving a test result that is obtained by testing the device under test based on the first test task comprises:
generating an abnormal signal based on a test parameter in the first test task and a type of the simulation interface parameter; and
driving the configured testing module to send the abnormal signal to the device under test for testing, and receiving the test result that is obtained by testing the device under test based on the first test task.

10. The method according to claim 6, wherein the first test task comprises multiple test subtasks, and the driving the configured testing module to execute the first test task to test the device under test, and receiving a test result that is obtained by testing the device under test based on the first test task comprises:
determining a first test parameter based on a first test subtask in the first test task;
driving the configured testing module to generate a first operating parameter based on the first test parameter;
sending the first operating parameter to the device under test for testing, and receiving a first test result that is obtained by testing the device under test based on the first operating parameter; and
if the first test result indicates that the device under test is in a normal operating state, determining a new first test parameter and a new first operating parameter based on a next test subtask, and returning to the step of driving the configured testing module to generate the first operating parameter based on the first test parameter until all test subtasks are completed.

11. The method according to claim 6, wherein the method further comprises:
establishing a communication connection between the configured testing module and the device under test;
sending a second operating parameter to the device under test, and receiving a second test result that is obtained by testing the device under test based on the second operating parameter; and
if the second test result indicates that the device under test is in a fault-cleared state, executing the step of parsing the test indication information to obtain a first test task.

12. The method according to claim 11, wherein the establishing a communication connection between the configured testing module and the device under test comprises:
extracting communication protocol information from a preset point configuration table; and
establishing the communication connection between the configured testing module and the device under test based on the communication protocol information.

13. The method according to claim 1, wherein the method further comprises:
reporting the test result to a host computer.

14. A testing system for energy storage valve control, wherein the testing system comprises a host computer, a testing device, and an energy storage control system, and the energy storage control system comprises at least a submodule controller, a main control chassis, and an expansion device; wherein
the testing device is configured to receive test indication information sent by the host computer, simulate, based on the test indication information, an associated device connected to a device under test in the energy storage control system, determine a simulation associated parameter, test the device under test based on the simulation associated parameter and the test indication information, and receive a test result of the device under test; wherein the simulation associated parameter comprises a simulation interface parameter or a simulation functional parameter.

15. A testing apparatus for an energy storage control system, wherein the testing apparatus comprises:
a receiving module configured to receive test indication information;
a simulation module configured to: simulate, based on the test indication information, an associated device connected to a device under test in the energy storage control system, and determine a simulation associated parameter; wherein the simulation associated parameter comprises a simulation interface parameter or a simulation functional parameter; and
a testing module configured to test the device under test based on the simulation associated parameter and the test indication information, and receive a test result of the device under test.

16. A computer device, comprising a memory and a processor, wherein the memory stores a computer program, and when the processor executes the computer program, the steps of the method according to any one of claims 1 to 13 are implemented.

17. A computer-readable storage medium, on which a computer program is stored, wherein when the computer program is executed by a processor, the steps of the method according to any one of claims 1 to 13 are implemented.
